(19) Europäisches Patentamt

European Patent Office

Office européen des brevets

(11) EP 1 404 763 B1

(12) EUROPÄISCHE PATENTSCHRIFT

(45) Veröffentlichungstag und Bekanntmachung des Hinweises auf die Patenterteilung:
05.10.2005 Patentblatt 2005/40

(21) Anmeldenummer: 02742774.9

(22) Anmeldetag: 21.05.2002

(51) Int Cl.$^7$: **C09C 1/00**, C23C 14/00

(86) Internationale Anmeldenummer:
**PCT/DE2002/001858**

(87) Internationale Veröffentlichungsnummer:
**WO 2002/094945 (28.11.2002 Gazette 2002/48)**

(54) **VERFAHREN ZUR HERSTELLUNG VON PLANPARALLELEN PLÄTTCHEN MITTELS ORGANISCHER TRENNMITTEL**

METHOD FOR THE PRODUCTION OF PLANE-PARALLEL PLATELETS BY USING ORGANIC SEPARATING AGENTS

PROCEDE DE PRODUCTION DE PLAQUETTES A FACES PARALLELES AU MOYEN D'UN AGENT DE SEPARATION ORGANIQUE

(84) Benannte Vertragsstaaten:
**AT BE CH CY DE DK ES FI FR GB GR IE IT LI LU MC NL PT SE TR**

(30) Priorität: **21.05.2001 DE 10124796**
**15.10.2001 DE 10150562**
**18.10.2001 DE 10151375**

(43) Veröffentlichungstag der Anmeldung:
**07.04.2004 Patentblatt 2004/15**

(73) Patentinhaber: **Ciba Specialty Chemicals Holding Inc.**
**4057 Basel (CH)**

(72) Erfinder: **Ciba Specialty Chemicals Holding Inc.**
**4057 Basel (CH)**

(56) Entgegenhaltungen:
**EP-A- 0 990 715      WO-A-00/24946**
**WO-A-01/25500      DE-A- 19 933 230**

## Beschreibung

Die vorliegende Erfindung betrifft ein Verfahren zur Herstellung von planparallelen Plättchen, die Verwendung der so hergestellten planparallelen Plättchen sowie die nach solchen Verfahren erhältlichen Produkte.

An planparallelen Plättchen bzw. "Flakes", meistens aus Aluminium oder aus Kombinationen von Metallen mit Oxiden, besteht großes Interesse zur Verwendung als Pigmente in Lacken und Druckfarben, als Katalysatormaterial, als Ausgangsprodukt für magnetische und elektrische Abschirmungen und als Ausgangsmaterial für Leitlacke. Diese Produkte unterscheiden sich von den klassischen, nach einem Mahlverfahren hergestellten Pigmenten, welche mehr oder weniger abgeflachte Kugeln sind und deshalb ein wesentlich ungünstigeres Verhältnis von Oberfläche zu Masse aufweisen.

Solche planparallelen Plättchen sind typischerweise 30-500 nm dick, die flächigen Abmessungen, d.h. die Kantenlängen, liegen typischerweise zwischen 5 und 50 µm.

Der Pigmentgehalt einer metallischen Autolackierung beträgt bei klassischen Mahlpigmenten ca. 80-100 g Aluminium, während für dieselbe Fläche bei Verwendung von planparallelen Plättchen aus Aluminium, die nach dem PVD- Verfahren ("Physical Vapour Deposition") hergestellt werden, bereits 4-5 g ausreichen. Planparallele Plättchen zeichnen sich somit durch eine bessere Wirtschaftlichkeit aus. Bereits 3-4 Lagen solcher Plättchen erzeugen bei Einsatzgewichten von nur 0,3 bis 0,4 g/m$^2$ Aluminium eine den Hintergrund optisch abdeckende Schicht.

Nach DE 19844357 C2 (Weinert) werden solche planparallelen Plättchen (Flakes) in einem kontinuierlichen Verfahren hergestellt, indem eine Trennmittelschicht und eine Produktschicht, zum Beispiel eine Aluminiumschicht, im selben Hochvakuum nacheinander im Durchlauf auf einen endlosen Träger aufgedampft werden, gefolgt von einer Auflösung des Trennmittels in einem Folgebad eines Lösungsmittels, welches sich ebenfalls unter Vakuum befindet. Die Produktschicht zerfällt dadurch in einzelne Flakes, welche dann in einer Suspension aus dem Lösemittel, dem gelösten Trennmittel und den Flakes vorliegen. Diese Suspension wird gesammelt, und die planparallelen Plättchen werden nach an sich bekannten Verfahren isoliert und zu Lacken oder Druckfarben weiterverarbeitet.

Ein weiteres, diskontinuierliches Mehrstufenverfahren wird zur Herstellung von optisch veränderlichen Pigmentplättchen verwendet, wie sie zur Erhöhung der Fälschungssicherheit von Banknoten verwendet werden (EP 227 423). Ein ähnliches Verfahren beschreibt das US-Patent Nr. 5,278,590. In den US-Patenten Nr. 4,168,985 (Venis), 3,123,489 (Bolomey et al.) und 5156720 (Rosenfeld) werden anorganische Salze als Trennmittel verwendet, welche in einem nachfolgenden Schritt mittels Wasser als Lösungsmittel aufgelöst werden, wodurch die Produktschicht als Flocken in wässriger Suspension vorliegt.

Nach WO99/65618 (Kittler) werden wachsartige Substanzen verdampft, worauf die Produktschicht im selben Vakuum aufgedampft oder gesputtert wird. Nach einer großen Anzahl von Umdrehungen des Trägers, meistens eines rotierenden Zylinders, wir das n-fache Schichtpaket (Wachs/Metall) abgeschabt. Das Wachs wird im gesammelten Brei in einem weiteren Schritt außerhalb der Vakuumanlage durch Lösungsmittel ausgewaschen. In allen Fällen werden große Mengen Lösungsmittel zum Auswaschen des Produktes benötigt. Diese müssen danach entweder aufgearbeitet oder entsorgt werden.

Zur Herstellung von planparallelen Plättchen aus Metallen wie Aluminium, Eisen, Kupfer und Titan sowie wasserlöslichen Verbindungen eignen sich Salze als Trennmittel nicht. Die großen Oberflächen dieser Plättchen reagieren unter Wasserstoffbildung mit dem Wasser bzw. die wasserlöslichen Verbindungen werden einfach aufgelöst. Die Metalloberflächen dieser Plättchen wird ferner durch die chemische Reaktion angegriffen und verliert ihre Oberflächenqualität. Im Falle von Kupfer reagiert das Anion des gelösten Salzes mit dem Metall.

Bei den nach dem PVD-Verfahren hergestellten Plättchen aus Quarz oder Titandioxid tritt demgegenüber keine Reaktion auf; Salze sind geeignete Trennmittel. Natriumchlorid, Natriumtetraborat (US 3,123,489; Bolomey et al.) sowie Natriumfluorid (US 4,168,986; Venis) und andere Salze sind als gut verdampfbare Substanzen bekannt, welche sich im PVD-Verfahren nicht zersetzen. Ihre Anwendbarkeit ist jedoch nicht gegeben, wenn die Produktschicht ein Metall sein soll und/oder Wasser als Lösungsmittel nicht verwendet werden kann.

Organische Verbindungen, welche sich im Vakuum weitgehend unzersetzt verdampfen lassen, wären hier angezeigt. Die Literatur kennt eine Reihe von Veröffentlichungen, nach denen sich solche organischen Stoffe nach dem PVD-Verfahren als transparente, elektrisch isolierende Schichten auf einen Träger aufdampfen lassen (siehe z. B. US-Patent Nr. 3,379, 803; Tittmann et al.).

Hier werden Polymerschichten durch Verdampfung von Xylylen-Verbindungen erzeugt. Diese Verbindungen bilden nach der Kondensation unter dem Einfluss von energiereichen Elektronen oder kurzwelligem, ultraviolettem Licht auf einem Träger Polymere, die unter der Gruppenbezeichnung Parylene bekannt sind. Die so erhaltenen Schichten eignen sich nicht als Trennmittelschichten, deren Aufgabe es ist, sich schnell in Lösungsmitteln aufzulösen. Vielmehr sind diese Schichten nach Römpp, Chemielexikon, Band 4, Seite 3130 sogar bei 400 °C gegen Lösungsmittel extrem beständig und werden insbesondere als sogenannte Barriereschichten bei der Halbleitererzeugung verwendet.

Weitere Beispiele für die Verdampfbarkeit von organischen Substanzen für derartige Schichten nach dem PVD-Verfahren sind in US 6,101,316 (Nagashima et al.), DE-OS 2706392 (Ikeda et al.), DE-OS 2009080 (Davies et al.) und US 3,547,683 (Williams, Hayes) beschrieben.

Nach diesen Veröffentlichungen werden Additions- und Kondensationspolymere, Silikonharze, Phthalocyanin-Farbstoffe und selbst Naturstoffe wie Kolophonium verdampft. Ein weiteres Verfahren, mit welchem organische Polymerschichten im PVD-Verfahren hergestellt werden, ist in US 5,440,446 (Shaw) beschrieben. Dort wird ein flüssiges Monomer verdampft, nass auf einem vorbeilaufenden Folienträger an einer gekühlten Walze kondensiert und an derselben Walze sofort durch Elektronenstrahlen-Beschuss polymerisiert, wodurch sich ein fester Film bildet. Im weiteren Verlauf wird eine Metallschicht, meistens Aluminium aufgedampft.

US 4,382,985 offenbart die Abscheidung eines Polymerfilms auf einem Substrat mittels Plasma-Polymerisation von Fluoralkylacrylat-Monomeren. Aus US 5,904,958 ist es bekannt, organische Monomere mittels Vakuumverfahren auf Substraten abzuscheiden und anschließend zu polymerisieren. Aus JP 11-140626 A (Patent Abstracts of Japan) ist es bekannt, einen dünnen Film aus Triazin-Monomeren z.B. mittels eines Vakuumverfahrens auf ein Substrat aufzubringen und anschließend zu polymerisieren.

Das Ziel all dieser Verfahren ist es, fest anhaftende Schutzschichten zu erzeugen. Eine schnelle Löslichkeit in Lösungsmitteln ist nicht erwünscht und wäre sogar schädlich.

Schließlich offenbaren DE 19933230 A1 und DE 19935181 A1 (Moosheimer et al.) Release-Schichten bzw. Schutzschichten aus vorzugsweise wasserlöslichen organischen Monomeren, insbesondere Triazin-Monomeren. Solche Schichten sind mit warmem Wasser ablösbar, welches indessen aufgrund seiner Reaktivität mit den erfindungsgemäß verwendeten Metallen ($H_2$-Entwicklung), aufgrund seines Rest-Sauerstoffgehaltes (schleichende Oxidation) bzw. aufgrund seiner erschwerten Entfernbarkeit aus den Produkten für das erfindungsgemäße Verfahren nicht in Frage kommt.

Die Aufgabe der vorliegenden Erfindung bestand nun darin, gegenüber dem vorgenannten Stand der Technik wie z.B. DE 19844357 C2 (Weinert) ein im wesentlichen verbessertes Verfahren zur Herstellung von planparallelen Plättchen nach dem PVD-Verfahren bereitzustellen.

Geeignete Trennmittel sollten vorzugsweise in einem kontinuierlichen PVD-Verfahren verwendbar sein und insbesondere im technischen Rahmen bei geringer thermischer Zersetzung in Mengen von über 1 kg/h verdampfbar sein. Die Mengen der entstehenden nicht kondensierbaren Crackgase sollten wesentlich geringer sein als die Kapazitäten der für solche Verfahren üblicherweise verwendeten Hochvakuumpumpen.

Die Trennmittel sollten auf einem kontinuierlich vorbei bewegten Träger von 0° bis etwa 50°C, vorzugsweise bei Raumtemperatur als amorphe Schicht kondensierbar sein. Sie sollten mit einer erfindungsgemäß auf die Trennmittelschicht aufgedampften Produktschicht aus Metallen wie z.B. Aluminium, Eisen, Kupfer, Silber, Zink, Zinn, Titan sowie Mischungen daraus, aus Fluoriden wie Magnesiumfluorid, aus Sulfiden wie Zinksulfid, aus Oxiden wie Siliziumdioxid und Titandioxid oder auch mit Mehrschichtsystemen aus diesen Stoffen möglichst wenig reagieren.

Die Trennmittelschicht zwischen dem Träger und der Produktschicht, aus der die planparallelen Plättchen gewonnen werden, sollte möglichst schnell löslich sein. Das zur Auflösung der Trennmittelschicht erforderliche Lösungsmittel darf auch nicht chemisch mit der dann zu feinen Flocken zerfallenden Produktschicht reagieren. Die zur Verfügung stehende Zeit ist durch die maximale Verweilzeit in der Ablösestrecke gegeben. Bei technischen Geschwindigkeiten des Trägers von 50-250 m/min beträgt diese Zeit typischerweise 5 bis 20 Sekunden, insbesondere 5 bis 10 Sekunden.

Diese Aufgabe wurde überraschend mit dem erfindungsgemäßen Verfahren gemäß Anspruch 1, den erfindungsgemäßen Verwendungen gemäß den Ansprüchen 11 bis 14 sowie dem erfindungsgemäßen Produkt gemäß Anspruch 15 gelöst. Die abhängigen Ansprüche betreffen bevorzugte Ausführungsformen.

Gegenstand der vorliegenden Erfindung ist demnach ein Verfahren zur Herstellung von planparallelen Plättchen mit den Schritten a) Aufdampfen eines Trennmittels auf einen Träger zum Erzeugen einer Trennmittelschicht bei einem Druck unterhalb des Atmosphärendruckes, b) Aufdampfen zumindest einer Produktschicht auf die Trennmittelschicht bei einem Druck unterhalb des Atmosphärendruckes, und c) Lösen der Trennmittelschicht in einem Lösungsmittel und Erzeugen einer Suspension, in der die zumindest eine Produktschicht in Form von planparallelen Plättchen vorliegt, welches dadurch gekennzeichnet ist, dass das Trennmittel aus der Gruppe, bestehend aus Anthracen, Anthrachinon, Acetamidophenol, Acetylsalicylsäure, Camphersäureanhydrid, Benzimidazol, Benzol-1,2,4-tricarbonsäure, Biphenyl-2,2-dicarbonsäure, Bis(4-hydroxyphenyl)-sulfon, Dihydroxyanthrachinon, Hydantoin, 3-Hydroxybenzoesäure, 8-Hydroxychinolin-5-sulfonsäure-monohydrat, 4-Hydroxycumarin, 7-Hydroxycumarin, 3-Hydroxynaphthalin-2-carbonsäure, Isophthalsäure, 4,4-Methylen-bis-3-hydroxynaphthalin-2-carbonsäure, Naphthalin-1,8-dicarbonsäureanhydrid, Phthalimid und dessen Kaliumsalz, Phenolphthalein, Phenothiazin, Saccharin und seinen Salzen, Tetraphenylmethan, Triphenylen, Triphenylmethanol, sowie Mischungen aus mindestens zwei dieser Stoffe, ausgewählt wird.

Die oben genannten Trennmittel genügen folgenden Bedingungen:

Es handelt sich um feste, nicht polymerisierbare organische Verbindungen mit Dampfdrücken von weniger als $10^{-3}$ Pa bei 25°C (Bedingung, um ein Material ohne Selbstverdampfung bei Raumtemperatur überhaupt in einem Vakuum von < 0,1 Pa einsetzen zu können).

Eine schnelle Löslichkeit der Trennmittelschicht in technischen Lösungsmitteln wie z.B. Isopropanol, Essigsäureethylester, Butanol, Ethanol, Benzin, Methylisobutylketon, Methylethylketon oder Perchlorethylen ist gegeben.

Die Trennmittel weisen unterhalb ihres Schmelzpunktes Dampfdrücke von 10 bis 1000 Pa auf. Es wird dadurch mit den erfindungsgemäßen Trennmitteln eine sublimative Verdampfung unterhalb des Tripelpunktes der Stoffe erreicht und eine technisch nachteilige Spritzerbildung vermeiden.

Die Trennmittel weisen darüber hinaus eine hohe thermische Stabilität auf und sind in technischen Mengen für die geplante Durchführung eines Produktionsprozesses verfügbar. Sie stehen in einem günstigen Preisverhältnis zu dem Metall bzw. dem Produkt, aus welchem die planparallelen Plättchen erzeugt werden sollen.

Zur Durchführung des erfindungsgemäßen Verfahrens besonders geeignet sind diejenigen der oben genannten Trennmittel, welche aromatische Strukturelemente, vorzugsweise vom homozyklischen Typ, im Molekül aufweisen, insbesondere aromatische Verbindungen mit mindestens einem Benzolring.

Außerdem kondensieren diese Stoffe amorph. Dies ist wichtig zur Erzielung von reflektierenden Metallschichten, welche auf die Trennmittelschicht aufgedampft werden sollen. Im PVD- Verfahren aufgedampfte Schichten geben genau die Struktur ihrer Unterlage wieder, da sie keinen einebnenden Effekt haben wie flüssig aufgebrachte Schichten, deren Oberflächenspannung diese Wirkung erzeugt.

Die vorliegende Erfindung wird anhand der nachfolgenden Beispiele, welche bevorzugte Ausführungsformen wiedergeben, und unter Bezugnahme auf die beigefügte Zeichnung näher erläutert.

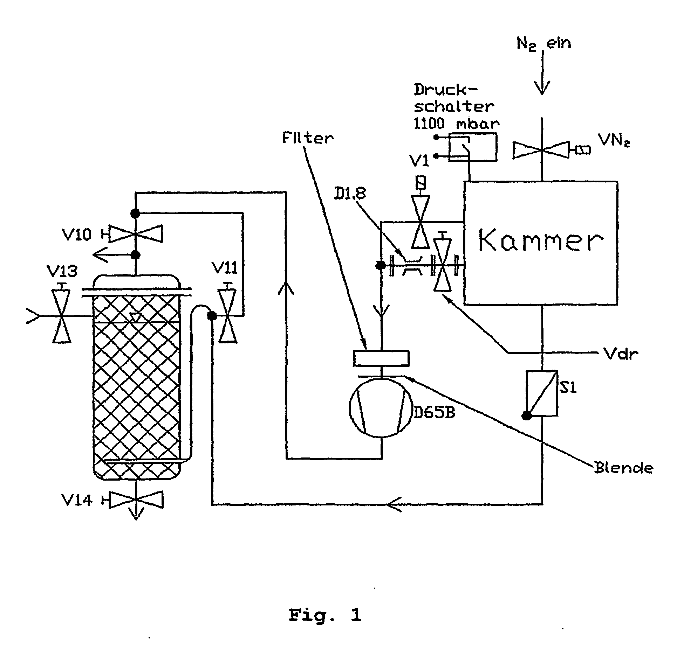

**Fig. 1** zeigt einen Versuchsaufbau zur Durchführung des erfindungsgemäßen Verfahrens. Die Anordnung nach Fig. 1 erwies sich als notwendig, da bei Verdampfungsversuchen mit Stoffen, über deren Verhalten in einem PVD-Verfahren keine Hinweise existieren, mit unbekannten Spaltstoffen zu rechnen war. In der nachfolgenden Liste ist eine Beschreibung der einzelnen Komponenten des Versuchsaufbaus gemäß Fig. 1 angegeben.

| Kammer | Vakuumkammer von 300 x 300 x 300 mm mit eingebautem thermischen Verdampfer, regelbar von 20-500 °C, Flüssigstickstoff-Falle zur Kondensation von Crackgasen, Ventilen, angebauten elektrischen Ventilen sowie einem Vakuummessgerät (nicht gezeigt) |
|---|---|
| V1 | Pumpventil |
| Vdr + D1.8 | Einstellbares Drosselventil über die Drosselbohrung D1.8 zum gedrosselten Pumpbetrieb während der Verdampfung (Minimierung des Einschleppens von Crackprodukten in die Vakuumpumpe) |
| Druckschalter | Sicherheitsmelder bei thermischer Zersetzung des zu prüfenden Trennmittels sowie bei einem Druckanstieg in der Kammer über $1,1 \times 10^5$ Pa (Auslösung der Abpumpung über die Absorptionssäule bei gleichzeitigem Einlass von Stickstoff in die Kammer) |
| $VN_2$ | Stickstoffeinlassventil für den Notfall, d.h. einem Druck von $> 1, 1 \times 10^5$ Pa |
| S1 | Rückschlagventil; die Leitung führt zur Absorptionssäule |
| D65B | 2-stufiger Drehschieberpumpsatz mit Turbopumpe; Endvakuum besser als $10^{-4}$ Pa ohne Vorfilter bzw. $10^{-3}$ Pa mit Vorfilter |
| V10 | Umgehungsventil der Absorptionssäule beim direkten Auspumpen der kalten Kammer |
| V11 | Leitet abgepumptes Gas durch die Absorptionssäule, wenn V10 geschlossen ist |
| V13 | Handventil, Zufuhr von frischem Absorptionsmittel |
| V14 | Entleerung von verbrauchtem Absorptionsmittel |

**Beispiel 1**

Ein ausgewähltes Trennmittel wurde in einer Menge von 20 Gramm in der Vakuumkammer nach Fig. 1 in einen beheizbaren Tiegel mit einer Öffnung von 10 x 1 cm eingefüllt. Der Tiegel wurde indirekt durch ein oberhalb angebrachtes Metallgitter aus Chromnickel 80Ni20Cr im direkten Stromdurchgang beheizt. Ein Probeblech als Kondensationsfläche von 250 x 250 x 1 mm wurde an der Kammerdecke befestigt. Die Kammer wurde auf $10^{-3}$ Pa evakuiert und das Metallgitter wurde langsam elektrisch auf eine Temperatur beheizt, welche 30 °C unter der bekannten Schmelztemperatur des Stoffes lag. Damit war sichergestellt, dass nur eine sublimative Verdampfung erfolgen kann. Während des Aufheizens des Tiegels mittels einer regelbaren Spannungsquelle erfolgte die Vakuummessung. Zeigte sich ein Zusammenbruch des Vakuum bis auf mehr als 1 Pa, wurde die Temperatur abgesenkt und nach 5 Minuten wieder auf 30 °C unterhalb der Schmelztemperatur erhöht. Damit konnten Ausgasungseffekte vor der Messung beseitigt werden. Trat der Vakuum- Zusammenbruch nochmals bis auf mehr als $10^{-1}$ Pa auf, musste auf eine mehr oder minder starke Zersetzung geschlossen werden. Die Kammer wurde nach jedem Versuch mit Stickstoffgas geflutet, das Probeblech wurde entnommen und gewogen. Die Aufdampfgeschwindigkeit konnte durch die Gewichtszunahme und die Verdampfungszeit berechnet werden. Um in einem industriellen Verfahren wirtschaftlich eingesetzt werden zu können, sollte das Trennmittel bei einer Sublimationstemperatur von 30° C unterhalb des Schmelzpunktes die folgende Bedingung erfüllen:

$$1/A * dm/dt \geq 0.15 \ g \ min^{-1} \ cm^{-2}$$

wobei:

A        die abdampfende Fläche (cm$^2$) und
dm/dt    die Verdampfungsgeschwindigkeit (g/sec) ist.

Die Verdampfung aus der flüssigen Phase war wegen der Gefahr einer Spritzer- und Schaumbildung durch entstehende Crackgase zu vermeiden. Der Wert von dm/dt $\geq$ 0.15 g min$^{-1}$ cm$^{-1}$ entspricht in etwa der Verdampfungsgeschwindigkeit aus einem klassischen Aluminiumverdampfer bei ca. 1450°C.

**Beispiel 2**

In selben Vakuum wurden ein ausgewähltes Trennmittel und anschließend eine Schicht aus Aluminium auf ein Probenblech aufgedampft. Die Schichtdicken betrugen ca. 40 nm für die Trennmittelschicht und ca. 45 nm für die Aluminiumschicht. Die Kondensationsgeschwindigkeit wurde über die Temperatur der Verdampfungsquelle auf 20-30 nm/sec eingestellt. Geringere Kondensationsgeschwindigkeiten sind von geringem Interesse, da sie in einem kontinuierlichen technischen Verfahren zu unbrauchbar kleinen Trägergeschwindigkeiten führen würden. Die Messung erfolgte nach bekannter Technik über einen Schwingquarz, welcher auf gleicher Ebene wie das Probenblech in dessen Mitte montiert wurde. Hierzu wurde die Mitte des Probenbleches entsprechend dem Durchmesser des Messkopfes durchbohrt, so dass sichergestellt war, dass die Schicht auf dem Schwingquarz und dem Probenblech gleich ist. Durch diesen Versuchsschritt konnte die Anzahl der verwendbaren Trennmittel eingegrenzt werden, da bei vielen organischen Stoffen festgestellt wurde, dass sie entweder auf der Trägeroberfläche nicht als amorphe Schicht kondensierten oder mit dem darauf aufgedampften Aluminium reagierten. Das Ergebnis waren matte, milchige, in vielen Fällen auch gelb gefärbte Schichten, die sich bei der Analyse mittels ESCA nach bekannter Technik als Aluminiumcarbide erwiesen. Ein Hinweis auf ein thermisches Cracken einzelner Stoffe war die Geruchsbildung, die nach dem Öffnen der Vakuumkammer geprüft wurde.

**Beispiel 3**

Die Apparatur bestand aus einem Tauchbad, in welches das vor und nach der Ablösung gewogene Probeblech eingetaucht wurde. Dadurch konnte die kondensierte Menge bestimmt werden. Die Auflösung der Trennmittelschicht und der aufgedampften Metallschicht vom Träger erfolgte bei gleichzeitiger Messung der Zeit, bis die Metallschicht sich ablöste und in Flocken zerfiel. Als Lösungsmittel wurden in der Versuchsreihe verwendet: Isopropanol, Essigsäureethylester, Butanol, Ethanol, Benzin, Methylisobutylketon, Methylethylketon. Mit diesem Verfahren konnte jeweils das für ein gewisses Trennmittel schnellste Lösungsmittel ermittelt werden.
Tabelle I gibt die Ergebnisse der in den Beispielen 1 bis 3 untersuchten Stoffe hinsichtlich ihrer Eignung als Trennmittel im erfindungsgemäßen Verfahren wieder.
Die Verdampfung von Polymeren ist aus der Literatur bekannt und chemisch schwer erklärbar. Es ist nicht möglich, dass ganze Ketten verdampfen. Sie werden vielmehr in Bruchstücke zerlegt, welche auf einer Kondensationsoberfläche unter Hochvakuum sofort wieder teilweise polymerisieren. Die IR-Spektroskopie und auch die weitere chemische Untersuchung zeigt, dass es sich beim Kondensat nicht um denselben Stoff handelt, der im Verdampfer vorlag. Das Molekulargewicht des Kondensats ist allgemein um 70-40 % niedriger. Polymere, die generell in Isopropanol, Ethanol, Benzin unlöslich sind, lösen sich als dünne Schicht von 30-100 nm unter Umständen trotzdem in solchen Lösungsmitteln auf.
Dennoch haben sich Polymere im Gegensatz zu den erfindungsgemäßen, nicht polymerisierbaren Trennmitteln als generell untauglich erwiesen, wie weiter unten noch ausgeführt wird.
Aus den unter Nr. 101 bis 228 aufgeführten chemischen Stoffen ließen sich geeignete Typen als nach dem erfindungsgemäßen PVD-Verfahren verdampfbare Trennmittel auswählen. Einige kondensieren, je nach Temperatur der Unterlage kristallin auf und geben der darauf kondensierten Metallschicht ein Satin-artiges Aussehen, welches bei Metallpigmenten in einigen Fällen sogar erwünscht sein kann.
Die Nachteile bei der Verwendung von Polymeren liegen darin begründet, dass sich die Polymere schlecht verdampfen lassen, dass die Aufrechterhaltung einer konstanten Verdampfungsgeschwindigkeit schwierig ist, dass die Polymere cracken und zum erheblichen Vakuumeinbruch führen können, dass sich Polymerschichten schwer (zum Teil unvertretbar langsam) auflösen lassen, dass sich verkohlte Rückstände im Verdampferbereich bilden, eine Sublimation nicht möglich ist und es zur Spritzerbildung kommen kann.

Es erweist sich auch, dass Trennmittel, die sich zwischen einem Träger und einer aufgedampften Metallschicht schnell genug auflösen, für ein kontinuierliches Verfahren zur Erzeugung von planparallelen Plättchen im PVD-Verfahren geeignet sind. Besonders geeignet sind die in der Tabelle I mit "< 5 sec." und "1" gekennzeichneten Stoffe, welche bei der Verdampfung im Vakuum eine geringe thermische Zersetzung und hernach eine schnelle Auflösbarkeit in organischen Lösungsmitteln aufweisen. Als besonders geeignete Trennmittel erwiesen sich aromatische Verbindungen mit mindestens einem Benzolring. (Bei technischen Bandgeschwindigkeiten des Trägers von ca. 200 Meter pro Minute und einer praktikablen Ablösestrecke von maximal 30 Metern stehen für die Auflösung des organischen Trennmittels maximal 6 Sekunden zur Verfügung. Es ist natürlich technisch möglich, die Länge einer solchen Ablösestrecke zu erhöhen oder die Ablösung durch mechanische Hilfsmittel zu unterstützen.)

Es ist weiterhin von Vorteil, das oder die Trennmittel in ausschließlichen Kontakt mit einem hitzebeständigen keramischen Feststoff zu bringen, diesen als Pulver oder Granulat beizumischen und die Mischung im Vakuum bis auf die notwendige Verdampfungstemperatur des Trennmittels zu erhitzen. Es zeigt sich, dass bei einigen erfindungsgemäßen Trennmitteln durch das Fehlen eines Kontaktes zu heißen Metalloberflächen so eine chemische oder katalytische Zersetzung wesentlich verringert werden kann.

Durch diese Erfindung wird die Möglichkeit eröffnet, im PVD-Verfahren aufgedampfte Metallschichten, wie Aluminium, Eisen, Titan, Kupfer und andere in einem kontinuierlichen, im geschlossenen Kreislauf arbeitenden Verfahren bei zeitlich begrenzter Verweilzeit in der Ablösezone durchzuführen.

Dem mit der Materie vertrauten Fachmann ist es naheliegend und möglich, Derivate und Mischungen zu den in Tabelle I genannten Stoffen als Trennmittel einzusetzen, um den gewünschten Erfolg zu erzielen. Ebenso gibt es bekannte Varianten der PVD-Verdampfungstechnik, bei welchen zwei oder mehrere Stoffe aus derselben Quelle oder aus zwei oder mehreren überlappenden Quellen verdampfen. Ferner ist es möglich, das organische Trennmittel der Verdampfungsquelle kontinuierlich zuzuführen.

Eine weitere Variante besteht darin, dass nacheinander eine Folge von Trennmittel, Produktschicht, Trennmittel, Produktschicht usw. aus 4 oder mehr Verdampferquellen in einem Durchlauf aufgetragen wird, bevor die nachfolgende Ablösung in einem Lösungsmittel gemeinsam erfolgt.

## TABELLE I

| No. | Trennmittel | Metallober-fläche | Ablösezeit * | Verdampfungstemperatur (Bemerkung) | Vakuumeinbruch** (Bemerkung) |
|---|---|---|---|---|---|
| 101 | Polyamid (DELRIN™) | glänzend | > 20 sec. | 270 °C (ätzender Geruch in der Vakuumkammer nach dem Öffnen) | 3 (ungeeignet) |
| 102 | Polystyrol | verfärbt | > 20 sec. | 240 °C (Styrolgeruch) | 3 (ungeeignet) |
| 103 | Polyester (Polyethy-lenterephthalat; PET) | glänzend | > 20 sec. | 305 °C (ätzender Geruch) | 3 (ungeeignet) |
| 104 | Polycarbonat (PC) (LEXAN™) | glänzend | > 20 sec. | 300 °C (geringer Geruch) | 3 (ungeeignet) |
| 105 | Poly-Methacrylat (PMMA) | glänzend | > 20 sec. | 265 °C (ätzender Geruch) | 3 (ungeeignet) |
| 106 | Polytetrafluorethylen (PTFE) | satiniert | > 50 sec. | 420 °C (beißender Geruch; Abbruch) | 3 (ungeeignet) |
| 107 | Polyimid (Kapton™) | verfärbt | > 50 sec. | 450 °C (mittelstarker Geruch) | 2 (ungeeignet) |
| 108 | Polyvinylcarbazol CAS-Nr. 25067-59-8 | glänzend | > 20 sec. | 240 °C (geringer Geruch) | 2 (ungeeignet) |
| 109 | Parylen | glänzend | Keine Ablösung | 360 °C | 2 (teuer und ungeeignet) |
| 201 | Saccharin-Natriumsalz CAS-Nr. 82325-42-0 | gelb verfärbt | < 5 sec. | 190 °C | 2 |
| 202 | Tetraphenylmethan CAS-Nr. 630-76-2 | satiniert | < 5 sec. | 255 °C | 1 (teuer) |
| 203 | Triphenylmethanol CAS-Nr. 76-84-6 | satiniert | < 5 sec. | 135 °C | 1 (teuer) |
| 204 | Phenolphthalein CAS-Nr. 77-09-8 | glänzend | 5-10 sec. | 230 °C | 2 |
| 205 | Triphenylen CAS-Nr. 217-59-4 | glänzend | 5-10 sec. | 170 °C | 1 |
| 206 | Acetamidophenol CAS-Nr. 621-42-1 | matt | > 10 sec. | 120 °C | 2 |

EP 1 404 763 B1

## TABELLE I (Fortsetzung)

| No. | Trennmittel | Metallober-fläche | Ablösezeit* | Verdampfungstemperatur (Bemerkung) | Vakuumeinbruch** (Bemerkung) |
|---|---|---|---|---|---|
| 207 | Acetylsalicylsäure CAS-Nr. 50-78-2 | glänzend | < 5 sec. | 110 °C | 1 |
| 208 | Camphersäure-Anhydrid CAS-Nr. 13429-83-9 | glänzend, leicht gelb | 5-10 sec. | 180 °C | 2 |
| 209 | Phenothiazin CAS-Nr. 92-84-2 | glänzend | 5-10 sec. | 160 °C | 1 |
| 210 | Anthracen CAS-Nr. 120-12-7 | glänzend | 5-10 sec. | 120 °C | 3 |
| 211 | Anthrachinon CAS-Nr. 84-65-1 | glänzend | 5-10 sec. | 250 °C | 2 |
| 212 | Gemisch aus 201 und 205 | matt gelb | 5-10 sec. | 170 °C | 2 |
| 213 | Benzimidazol CAS-Nr. 51-17-2 | matt | 5-10 sec. | 140 °C | 2 |
| 214 | Benzol-1,2,4-tricar-bonsäure CAS-Nr. 528-44-9 | gelblich | < 5 sec. | 210 °C | 1 |
| 215 | Biphenyl-2,2-dicar-bonsäure CAS-Nr. 482-05-3 | glänzend | < 5 sec. | 190 °C | 1 |
| 216 | Bis(4-hydroxyphenyl)-sulfon CAS-Nr. 80-09-1 | gelblich | 5-10 sec. | (starke Zersetzung) | 3 |
| 217 | Dihydroxyanthrachinon CAS-Nr. 81-64-1 | matt | 5-10 sec. | 160 °C | 3 |
| 218 | Hydantoin CAS-Nr. 461-72-3 | glänzend | 5-10 sec. | 190 °C | 2 |
| 219 | 3-Hydroxybenzoesäure CAS-Nr. 99-96-7 | gelblich | < 5 sec. | 170 °C | 3 |

EP 1 404 763 B1

## TABELLE I (Fortsetzung)

| No. | Trennmittel | Metallober-fläche | Ablösezeit * | Verdampfungstemperatur (Bemerkung) | Vakuumeinbruch** (Bemerkung) |
|---|---|---|---|---|---|
| 220 | 8-Hydroxychinolin-5-sulfonsäuremonohydrat CAS-Nr. 84-88-8 | gelblich | 5-10 sec. | 280 °C | 3 |
| 221 | 4-Hydroxycumarin CAS-Nr. 1076-38-6 | glänzend | 5-10 sec. | 180 °C | 2 |
| 222 | 7-Hydroxycumarin CAS-Nr. 93-35-6 | glänzend | 5-10 sec. | 180 °C | 2 |
| 223 | 3-Hydroxynaphthalin-2-carbonsäure CAS-Nr. 86-48-6 | glänzend | 5-10 sec. | 170 °C | 3 |
| 224 | Isophthalsäure CAS-Nr. 121-91-5 | glänzend | 5-10 sec. | 270 °C | 2 |
| 225 | 4,4- Methylen-bis-3-hydroxynaphthalin-2-carbonsäure CAS-Nr. 130-85-8 | matt | 5-10 sec. | 250 °C | 2 |
| 226 | Naphthalin-1,8-dicar-bonsäureanhydrid CAS-Nr. 81-84-5 | glänzend | < 5 sec. | 220 °C | 1 |
| 227 | Phthalimid CAS-Nr. 85-41-6 | glänzend | < 5 sec. | 190 °C | 2 |

*: Relative Zeit unter gleichen Versuchsbedingungen durch Eintauchen bei 25°C in das am **schnellsten wirkende** Lösungsmittel, ausgewählt aus der Gruppe, bestehend aus Isopropanol, Essigsäureethylester, Ethanol, Benzin, Methylisobutylketon, Methylethylketon

**: Ein Druckanstieg [Pa] von bis zu: $7 \times 10^{-2}$     $2 \times 10^{-1}$     $> 2 \times 10^{-1}$
entspricht einer Bewertung von    1: gering    2: mittel    3: stark

Dieser Anstieg hängt von der verwendeten Versuchsapparatur und der installierten Saugleistung der Vakuumpumpen ab. Er wird hier als Vergleichswert angegeben.

EP 1 404 763 B1

Die nach dem erfindungsgemäßen Verfahren hergestellten planparallelen Plättchen weisen im Gegensatz zu Pigmenten nach dem Stand der Technik weitere Vorteile insbesondere hinsichtlich ihrer weiteren Verarbeitbarkeit auf.

Metallpigmente aus Aluminium nach dem Stand der Technik, die bereits großtechnisch im CVD-Verfahren weiter beschichtet werden, stammen alle aus Mahlvorgängen, welche unter Zugabe von Testbenzin und Stearaten in Kugelmühlen durchgeführt werden. Die Entfernung solcher Restschichten ist aufwendig, nicht vollkommen möglich und erfordert mehrfache Waschvorgänge mit reinem Lösungsmittel in Kaskadenanordnung. Ein Beispiel, welches gemahlenes Aluminium als Grundmaterial benutzt, ist unter EP 0708154 (Schmid und Mronga) beschrieben. Durch CVD-Beschichtung mit $SiO_2$ und einer absorbierenden Schicht wird ein Interferenz-Pigment erzeugt.

Ein Abdampfen von organischen Schutzschichten bei Halbleiteranwendungen beschreibt DE 19935181 C2 (Moosheimer). Diese Schichten werden auch als durch Abdampfen entfernbare Masken bezeichnet.

Nach dem Stand der Technik werden anorganische Salze, wie z.B. nach US 3,123,489 (Bolomey et al.) als Trennmittel zur Herstellung von Schichten aus Zinksulfid, Fluoriden oder Oxiden aufgedampft. US 6,270,840 (Weinert) verwendet ebenfalls aufgedampfte Salzschichten als Trennmittel in einem kontinuierliche Verfahren, bei welchem alle Schritte gleichzeitig unter Vakuum stattfinden. Salze lösen sich zwar in Wasser von den Oberflächen der planparallelen Plättchen vollkommen ab, haben aber den Nachteil, dass sie bei der Herstellung von Plättchen aus Kupfer, Silber oder Zinn, die als Leitlacke verwendet werden können zu einer raschen chemischen Korrosion dieser Metalle im Ablösebad aus Wasser führen, insbesondere, da aus den in Lösung gegangenen verdampften Salzen Anionen vorliegen.

Gegenüber dem Stand der Technik der Lackierung von Kunststofffolien, anschließender Aufdampfung von Metallschichten oder Kombinationen von Metall-, Oxid- oder Fluoridschichten im PVD-Verfahren (z.B. Chrom, Siliziumoxid oder Magnesiumfluorid) und Auflösung der Lackschicht in einem organischen Lösungsmittel unter Erzeugung von planparallelen Plättchen aus solchen Materialien, besitzt die Verwendung der erfindungsgemäßen Trennmittel den wesentlichen Vorteil, dass sie keine an den Produktschichten angelagerten Polymere oder Oligomere zurücklassen. Sie lassen die Trennmittel vielmehr in monomolekularer Schicht zurück.

Demgegenüber bilden angelagerte Polymere an den Oberflächen der planparallelen Plättchen, deren Metallschicht typischerweise nur 40 nm dick ist, Anlagerungen von etwa zwei mal 10 bis 15 nm, also 50 bis 75 Vol.-%. Die erfindungsgemäßen Trennmittelschichten lassen aufgrund ihrer wesentlich kleineren Molekülgröße nur Rückstände von etwa 10 bis 15 Vol.-% zurück.

Üblicherweise werden die nach dem erfindungsgemäßen Verfahren hergestellten planparallelen Plättchen gleich in Form der anfallenden Suspension weiter verarbeitet. Es ist aber auch möglich, die nach dem erfindungsgemäßen Verfahren hergestellten planparallelen Plättchen weiter zu reinigen.

In einem Folgeschritt lassen sich die verbleibenden monomolekularen Schichten rückstands frei entfernen, indem man sie unter einem Vakuum von $10^{-3}$ bis 10 Pa von den erzeugten planparallelen Plättchen weitgehend rückstandsfrei abgedampft. Das abgedampfte Trennmittel wird an kalten Kondensatorflächen als Feststoff abgeschieden und entsorgt. Die Verdampfungstemperaturen betragen hierbei weniger als 350°C, vorzugsweise weniger als 300°C.

Auf diese Weise gereinigte, planparallele metallische Plättchen ohne elektrisch isolierende Schichten an ihren Oberflächen eignen sich z.B. zur Herstellung von Leitlacken, d.h. von elektrisch leitfähigen Dispersionen. Aufgrund ihrer geringen Teilchengröße eignen sich solche Plättchen aber auch für Auftragsverfahren durch Tintenstrahldruck, Tiefdruck und Flexodruck. Auch die Kontaktierung von Anschlussstellen an elektronischen Bauteilen oder Photovoltaik-Bauteilen wird dadurch wesentlich vereinfacht.

Diese Verfahrensweise wäre bei anhaftenden Oligomeren oder Polymeren nicht möglich, welche sich thermisch zersetzen würden und deren Crack-Produkte zu einer wesentlichen Verfärbung der planparallelen Plättchen führen. Dadurch gingen das metallische Aussehen und die elektrische Leitfähigkeit zumindest zum Teil verloren.

Der oben verwendete Begriff "rückstandsfrei" ist hier derart definiert, dass keine zusammenhängende monomolekulare Schicht des organischen Trennmittels mehr an der Oberfläche vorhanden ist. Dies erfordert, dass die mittlere theoretische Schichtdicke von Verschmutzungen durch Trennmittel kleiner als etwa 0.5 nm ist. Dies entspricht einem "Rückstand" von maximal 0.6 mg pro $m^2$ bei einer Dichte des Trennmittels von ca. 1.2 $g/cm^3$. Die Oberflächen sind also nur noch durch nicht zusammenhängende Inseln belegt.

Ein Beispiel eines geeigneten Messverfahrens besteht darin, eine Menge von 100 g trockener Aluminiumplättchen von 40 nm Dicke, entsprechend einer berechneten Oberfläche von 1000 $m^2$ in einer allseitig beheizten Vakuumkammer auf ca. 400°C zu erhitzen und den Druckanstieg durch die gasförmigen Zersetzungsprodukte zu messen. Eine Vergleichsmessung des Druckanstieges mit 0.6 Gramm des selben Trennmittels allein gibt einen Eichwert. Angenommen wird bei dieser Bestimmung, dass sich die Trennmittel, auf denen diese Erfindung beruht, thermisch vollkommen in gasförmige Komponenten zersetzen, ohne Crackprodukte zurückzulassen, was auch tatsächlich zutrifft.

Eine Weiterverarbeitung der so erzeugten, thermisch gereinigten planparallelen Plättchen zu Druckfarben, Spritzlacken oder trockenen Pulverlacken ist deshalb wesentlich besser durchführbar. Auf eine chemische Verträglichkeit von organischen Rückständen muss nicht Rücksicht genommen werden, da solche nach dem Abdampfen nicht mehr in nennenswertem Ausmaß anwesend sind.

Die auf diese Weise geschaffenen trockenen, von organischen Rückständen befreiten, nach dem PVD-Verfahren erzeugten planparallelen Plättchen können nun mit anderen Substanzen in einem weiteren Schritt, der nach der Zerkleinerung und Klassierung der Plättchen nach Größe durch an sich bekannte Verfahren erfolgt, mit weiteren Substanzen beschichtet werden, ohne dass organische Restschichten einen störenden Einfluss auf die weitere Beschichtung ausüben.

Beispiele für solche Substanzen, die zur Modifizierung von Oberflächen dienen, sind unter den Handelsbezeichnungen DYNASYLAN™, HYDROSIL™, PROTECTOSIL™ bekannt. Damit werden hydrophile oder hydrophobe Eigenschaften der Oberflächen oder Kopplereigenschaften zur Anlagerung anderer organischer Stoffe erzielt.

Es ist auch möglich, solche auf diese Weise hergestellten, von störenden organischen Restschichten befreite, nach dem PVD-Verfahren hergestellten planparallelen Plättchen aus Metallen, wie z.B. Aluminium, Silber oder Kupfer einer nachfolgenden CVD- Behandlung in einem weiteren Verfahren zu unterziehen.

Hierzu werden die planparallelen Plättchen in einem gasdichten Behälter einer Strömung eines schichtbildenden Gases bei Temperaturen von über 150°C ausgesetzt. Solche bekannten CVD-Verfahren wären unmöglich oder wesentlich erschwert, wenn an den nach dem PVD-Verfahren hergestellten Plättchen noch organische Reste von Lackpolymeren anhaften würden, wie dies bei den beschriebenen Verfahren nach dem Stand der Technik der Fall wäre. Der Versuch eines Abdampfens solcher Stoffe würde zu zurückbleibenden, fest anhaftenden Crackprodukten führen.

Vorteilhaft ist ferner, die so hergestellten, gereinigten Metalloberflächen von im PVD-Verfahren hergestellten planparallelen Plättchen mit organischen Farbstoffen zu beschichten, und zwar entweder direkt oder durch vorheriges, nasschemisches Aufbringen einer 30 - 100 nm dicken Kopplerschicht nach an sich bekannten Verfahren.

Solche Farbstoffe, z.B. Phthalocyanin, Benzimidalozone wie NOVOPERM®, CROMOPHTAL®, GRAPHTOL®, Diketopyrrolopyrrole (DPP) und Isoindoline mit den Markenbezeichnungen PALIOTOL® aber auch Perylen-Pigmente besitzen eine ausreichende thermische Stabilität, um in einem Vakuum von 1 bis $10^{-2}$ Pa auf nach dem PVD-Verfahren hergestellte, gereinigte planparallele Plättchen aufgedampft zu werden.

Die Metallplättchen werden hierbei auf an sich bekannte Weise als Schüttgut laufend bewegt, bis sie in einer dünner Schicht aus diesen organischen Materialien eingebettet sind und gleichzeitig eine mehr oder weniger starke Pastellfarbe aufweisen, welche von der aufgetragenen Schichtdicke abhängt. Die so erzeugten Schichten dienen hierbei gleichzeitig als chemische Schutzschichten bei der Verwendung solcher Produkte in Lacken mit wässrigen Lösungsmitteln.

Die Doppelfunktion solcher eingebetteter planparalleler Plättchen ist die eines gefärbten Reflektors und gleichzeitig, wenn Aluminium als Plättchenmaterial verwendet wird, dessen Schutz gegen die bekannte Wasserstoffentwicklung durch Reaktion von Wasser mit Aluminium. So wird eine unakzeptable Blasenbildung in der Lackschicht bei Trocknungstemperaturen ab 50°C vermieden. Der Nachteil, dass der Schritt der Beschichtung nach erfolgtem Abdampfen der Trennmittelreste eine eigene Apparatur erfordert und nach dem mechanischen Zerkleinern der Plättchen als letzter Schritt erfolgen muss, wird durch diese erzielte Doppelfunktion aufgewogen.

Folgende Beispiele sollen die Verwendung der hier beschriebenen organischen Trennmittel weiter beschreiben:

### Beispiel 4:

Erzeugung von planparallelen Plättchen aus Aluminium, ohne weitere Behandlung, d.h. mit ca. 5 Gewichtsprozent Rückstand von Trennmittel an den Plättchen.

| Schritt 1 | Aufdampfen einer 30 nm Schicht von Phenolphthalein auf einen endlosen, bandförmigen Träger im Verfahren nach US 6,270,840 bei 300°C Verdampfungstemperatur und einem Vakuum von $10^{-2}$ Pa. |
|---|---|
| Schritt 2 | Im selben Vakuum und im selben Durchlauf: Aufdampfen einer 40 nm dicken Aluminiumschicht. |
| Schritt 3 | Nach Durchfahren von 2 Schleusenstufen in einen Vakuumraum von 5000 Pa: Die Doppelschicht wird bei laufendem Band Isopropylalkohol ausgesetzt. Die Aluminiumschicht zerfällt in feine Flocken und löst sich von Band ab. Die Suspension wird unter Vakuum gesammelt. |
| Schritt 4 | Die Suspension wird aus dem Vakuumraum ausgetragen, und die Suspension wird durch Zentrifugieren auf 25% Festkörpergehalt konzentriert. Der Vorgang wird mit frischem Isopropylalkohol 3 Mal wiederholt. |
| Schritt 5 | Weiterverarbeitung durch Zerkleinerung und Klassieren, vor der Verarbeitung in einem Lack. |

### Beispiel 5:

Erzeugung von planparallelen Plättchen aus Silber mit gereinigter Oberfläche.

| Schritt 1 | Aufdampfen einer 30 nm Schicht von Phenolphthalein auf einen endlosen, bandförmigen Träger im Verfahren nach US 6,270,840 bei 300°C Verdampfungstemperatur und einem Vakuum von $10^{-2}$ Pa. |
|---|---|
| Schritt 2 | Im selben Vakuum und im selben Durchlauf: Aufdampfen einer 90 nm dicken Silberschicht. |
| Schritt 3 | Nach Durchfahren von 2 Schleusenstufen in einen Vakuumraum von 5000 Pa: Die Doppelschicht wird bei laufendem Band Isopropylalkohol ausgesetzt. Die Silberschicht zerfällt in feine Flocken und löst sich von Band ab. Die Suspension wird unter Vakuum gesammelt. |
| Schritt 4 | 5 kg der Suspension aus 10% Silber, 1% gelöstem Phenolphthalein und 89% Isopropylalkohol wird aus dem Vakuumraum ausgetragen, und die Suspension wird durch Zentrifugieren konzentriert auf 50 Gew.-% Festkörpergehalt. |
| Schritt 5 | Zerkleinern der Silberteilchen in Suspension durch Ultraschall, Trennung der Teilchengrößen durch Sedimentation. |
| Schritt 6 | Einbringen der Suspension in eine zweite Vakuumapparatur und Eindampfung bei 5000 Pa und steigender Temperatur von 25 auf 60°C. |
| Schritt 7 | Weiteres Erhitzen der Suspension in der selben Vakuumapparatur, die Wandtemperatur ist erhöht auf 300°C, bei gleichzeitigem Umwälzen und Niederschlagen des verdampften Phenolphthalein an einer -196 °C bis + 25°C kalten Kondensorfläche. |
| Schritt 8 | Die so erhaltenen trockenen, an ihren Oberflächen von Verunreinigung befreiten Silberplättchen werden zur Weiterverarbeitung zu einem elektrisch leitenden Lack abgefüllt. |

**Beispiel 6:**

Erzeugung von planparallelen Kupfer-Plättchen mit reiner Oberfläche mit nachfolgender, allseitiger Beschichtung mit einem Silan-Oligomer. Die Schritte 1-7 sind identisch mit denen aus Beispiel 5. Statt Silber wurde Kupfer verwendet.

| Schritt 8 | 500 g der auf etwa Raumtemperatur abgekühlten Kupferplättchen werden in ein Bad aus 10 Liter Isopropylalkohol mit 100 g darin gelöstem Silan-Oligomer DYNASYLAN® Ameo (CAS Nr. 919-30-2 *) unter Normaldruck dispergierend eingebracht. Es erfolgt eine Wasserzugabe von 0,55 Litern bei 25°C. Nach etwa 20 Minuten scheidet sich in dem intensiv bewegten Bad eine hydrophile, transparente Schicht von 20-30 nm ab. |
|---|---|
| Schritt 9 | Die Suspension wird gefiltert und die beschichteten Plättchen werden bei 100°C im Luftstrom eines Fließbetts getrocknet. |
| Schritt 10 | Das trockene Produkt ist verwendbar als Pigment in dekorativen Kupferton- Lacken. Das Produkt schwimmt in Lacken nicht an der Oberfläche auf. |

*: Hersteller: Degussa-Hüls AG, Werk Rheinfelden

Allgemein führt eine höhere Wasserzugabe zu stärkerer Hydrolyse und schnellerer aber ungleichförmiger Beschichtung. Im Falle von Aluminium sollte der Transport der hergestellten planparallelen Plättchen in das Bad aufgrund der Reaktivität des Aluminiums unter Schutzgas erfolgen.

Die nach Schritt 10 gewonnenen planparallelen Plättchen können mit organischen Farbstoffen im PVD-Verfahren bedampft werden.

**Patentansprüche**

1. Verfahren zur Herstellung von planparallelen Plättchen mit den Schritten

   a) Aufdampfen eines Trennmittels auf einen Träger zum Erzeugen einer Trennmittelschicht bei einem Druck unterhalb des Atmosphärendruckes,

   b) Aufdampfen zumindest einer Produktschicht auf die Trennmittelschicht bei einem Druck unterhalb des Atmosphärendruckes, und

c) Lösen der Trennmittelschicht in einem Lösungsmittel und Erzeugen einer Suspension, in der die zumindest eine Produktschicht in Form von planparallelen Plättchen vorliegt,

**dadurch gekennzeichnet, dass** das Trennmittel aus der Gruppe, bestehend aus Anthracen, Anthrachinon, Acetamidophenol, Acetylsalicylsäure, Camphersäureanhydrid, Benzimidazol, Benzol-1,2,4-tricarbonsäure, Biphenyl-2,2-dicarbonsäure, Bis(4-hydroxyphenyl)-sulfon, Dihydroxyanthrachinon, Hydantoin, 3-Hydroxybenzoesäure, 8-Hydroxychinolin-5-sulfonsäure-monohydrat, 4-Hydroxycumarin, 7-Hydroxycumarin, 3-Hydroxynaphthalin-2-carbonsäure, Isophthalsäure, 4,4-Methylen-bis-3-hydroxynaphthalin-2-carbonsäure, Naphthalin-1,8-dicarbonsäureanhydrid, Phthalimid und dessen Kaliumsalz, Phenolphthalein, Phenothiazin, Saccharin und seinen Salzen, Tetraphenylmethan, Triphenylen, Triphenylmethanol, sowie Mischungen aus mindestens zwei dieser Stoffe, ausgewählt wird.

2. Verfahren nach Anspruch 1, **dadurch gekennzeichnet, dass** die Produktschicht Aluminium, Eisen, Kupfer, Silber, Zink, Zinn, Titan sowie Mischungen daraus umfasst.

3. Verfahren nach einem der Ansprüche 1 bis 2, **dadurch gekennzeichnet, dass** der Druck in den Schritten a) und b) im Bereich von $10^{-3}$ bis 0,5 Pa und im Schritt c) im Bereich von 10 bis $2 \times 10^{5}$ Pa liegt.

4. Verfahren nach einem der Ansprüche 1 bis 3, **dadurch gekennzeichnet, dass** das Lösungsmittel Isopropanol, Essigsäureethylester, Butanol, Ethanol, Benzin, Methylisobutylketon, Methylethylketon, Perchlorethylen sowie Mischungen daraus umfasst.

5. Verfahren nach einem der Ansprüche 1 bis 4, **dadurch gekennzeichnet, dass** das Trennmittel aus einem Gemisch mit einem keramischen Werkstoff in Granulat- oder Pulverform verdampft wird, wobei der keramische Werkstoff unverdampft als Rückstand verbleibt.

6. Verfahren nach einem der Ansprüche 1 bis 5, **dadurch gekennzeichnet, dass** das Trennmittel aus einem Tiegel mit keramischer oder gläserner Oberfläche oder einer Quarzoberfläche verdampft wird.

7. Verfahren nach einem der Ansprüche 1 bis 6, **dadurch gekennzeichnet, dass** das Trennmittel unter Vakuum kontinuierlich oder in Zeitintervallen der Verdampfungsquelle zugeführt wird.

8. Verfahren nach einem der Ansprüche 1 bis 7, **dadurch gekennzeichnet, dass** vor dem Lösen der Trennmittelschicht ein Schichtenverbund aufgedampft wird, der aus mehr als zwei Schichten besteht, wobei sich jeweils eine weitere Trennmittelschicht zwischen jeweils zwei Produktschichten befindet.

9. Verfahren nach einem der Ansprüche 1 bis 8, **dadurch gekennzeichnet, dass** die Trennmittelschicht eine Dicke von ca. 10 nm bis ca. 200 nm und die Produktschicht eine Dicke von ca. 10 nm bis ca. 500 nm, insbesondere von ca. 10 nm bis ca. 300 nm, aufweist.

10. Verfahren nach einem der Ansprüche 1 bis 9, **gekennzeichnet durch** den folgenden weiteren Schritt:

    d) Entfernen von Trennmittelresten **durch** Abdampfen bei bis zu 350°C und einem Vakuum von 10 bis $10^{-3}$ Pa.

11. Verfahren nach Anspruch 10, **gekennzeichnet durch** den folgenden weiteren Schritt:

    e) Aufbringen von hydrophoben Schichten, hydrophilen Schichten oder Koppelschichten aus Silan-Oligomeren auf die in Schritt d) **durch** Abdampfen erzeugten gereinigten Oberflächen der im PVD-Verfahren erzeugten planparallelen Plättchen.

12. Produkt, erhältlich nach Anspruch 10, **dadurch gekennzeichnet, dass** keine zusammenhängende monomolekulare Schicht des Trennmittels mehr an der Oberfläche vorhanden ist.

13. Produkt, erhältlich nach Anspruch 11, **dadurch gekennzeichnet, dass** keine zusammenhängende monomolekulare Schicht des Trennmittels mehr an der Oberfläche vorhanden ist.

14. Verwendung des Produkts nach Anspruch 12 zur Herstellung von Leitlacken sowie als Metallpigment in Lacken und Druckfarben.

**15.** Verwendung des Produkts nach Anspruch 13 in Lacken und Dispersionen mit Lösungsmitteln auf Wasserbasis.

**16.** Verwendung des Produkts nach Anspruch 12 als Reflektorplättchen zum nachfolgenden Aufdampfen von organischen Farbstoffen nach dem PVD-Verfahren bei gleichzeitiger Bewegung des Schüttgutes in einem Vakuum von 10 bis $10^{-3}$ Pa.

**17.** Verwendung des Produkts nach Anspruch 13 als Reflektorplättchen zum nachfolgenden Aufdampfen von organischen Farbstoffen nach dem PVD-Verfahren durch Bedampfung eines bewegten Schüttgutes bei einem Vakuum von 10 bis $10^{-3}$ Pa.

**Claims**

**1.** A method for the production of plane-parallel platelets, comprising the steps:

a) vapour-deposition, at a pressure below atmospheric pressure, of a separating agent onto a carrier to produce a separating agent layer,

b) vapour-deposition, at a pressure below atmospheric pressure, of at least one product layer onto the separating agent layer, and

c) dissolution of the separating agent layer in a solvent and production of a suspension in which the at least one product layer is present in the form of plane-parallel platelets,

**in which method** the separating agent is selected from the group consisting of anthracene, anthraquinone, acetamidophenol, acetylsalicylic acid, camphoric anhydride, benzimidazole, benzene-1,2,4-tricarboxylic acid, biphenyl-2,2-dicarboxylic add, bis(4-hydroxyphenyl)sulfone, dihydroxyanthraquinone, hydantoin, 3-hydroxybenzoic acid, 8-hydroxyquinoline-5-sulfonic acid monohydrate, 4-hydroxycoumarin, 7-hydroxycoumarin, 3-hydroxynaphthalene-2-carboxylic acid, isophthalic acid, 4,4-methylene-bis-3-hydroxynaphthalene-2-carboxylic acid, naphthalene-1,8-dicarboxylic anhydride, phthalimide and its potassium salt, phenolphthalein, phenothiazine, saccharin and its salts, tetraphenylmethane, triphenylene, triphenylmethanol, and also mixtures of at least two of those substances.

**2.** A method according to claim 1, wherein the product layer encompasses aluminium, iron, copper, silver, zinc, tin, titanium and also mixtures thereof.

**3.** A method according to either claim 1 or claim 2, wherein the pressure in steps a) and b) is in the range from $10^{-3}$ to 0.5 Pa and in step c) is in the range from 10 to $2 \times 10^{5}$ Pa.

**4.** A method according to any one of claims 1 to 3, wherein the solvent encompasses isopropanol, ethyl acetate, butanol, ethanol, petroleum spirit, methyl isobutyl ketone, methyl ethyl ketone, perchloroethylene and also mixtures thereof.

**5.** A method according to any one of claims 1 to 4, wherein the separating agent is vaporised from a mixture comprising a ceramic material in granule or powder form, the ceramic material remaining unvaporised as a residue.

**6.** A method according to any one of claims 1 to 5, wherein the separating agent is vaporised from a crucible having a ceramic or glass surface or a quartz surface.

**7.** A method according to any one of claims 1 to 6, wherein the separating agent is fed in to the vaporisation source, *in vacuo,* continuously or at time intervals.

**8.** A method according to any one of claims 1 to 7, wherein, before the separating agent layer is dissolved, there is vapour-deposited a combination of layers consisting of more than two layers, a further separating agent layer being located between every two product layers.

**9.** A method according to any one of claims 1 to 8, wherein the separating agent layer has a thickness of from about 10 nm to about 200 nm and the product layer has a thickness of from about 10 nm to about 500 nm, especially from about 10 nm to about 300 nm.

10. A method according to any one of claims 1 to 9, comprising the following further step:

   d) removal of separating agent residues by vaporisation at up to 350°C and under a vacuum of from 10 to $10^{-3}$ Pa.

11. A method according to claim 10, comprising the following further step:

   e) application of hydrophobic layers, hydrophilic layers or coupling layers comprising silane oligomers to the cleaned surfaces - produced by vaporisation in step d) - of the plane-parallel platelets produced by the PVD method.

12. A product obtainable according to claim 10, wherein a cohesive monomolecular layer of the separating agent is no longer present on the surface.

13. A product obtainable according to claim 11, wherein a cohesive monomolecular layer of the separating agent is no longer present on the surface.

14. Use of the product according to claim 12 in the production of conductive surface-coating compositions and as metal pigment in surface-coating compositions and printing inks.

15. Use of the product according to claim 13 in surface-coating compositions and dispersions with water-based solvents.

16. Use of the product according to claim 12 as reflector platelets in the subsequent vapour-deposition of organic dyes by the PVD method with simultaneous agitation of the loose material under a vacuum of from 10 to $10^{-3}$ Pa.

17. Use of the product according to claim 13 as reflector platelets in the subsequent vapour-deposition of organic dyes by the PVD method by subjecting agitated loose material to vapour-deposition under a vacuum of from 10 to $10^{-3}$ Pa.


**Revendications**

1. Procédé de production de paillettes à faces planes et parallèles comprenant les étapes consistant à :

   a) déposer en phase vapeur un agent de séparation sur un support afin d'obtenir une couche d'agent de séparation sous une pression inférieure à la pression atmosphérique,
   b) déposer en phase vapeur au moins une couche de produit sur la couche d'agent de séparation sous une pression inférieure à la pression atmosphérique, et
   c) dissoudre la couche d'agent de séparation dans un solvant et former une suspension dans laquelle la au moins une couche de produit est présente sous la forme de paillettes à faces planes et parallèles,

   **caractérisé en ce que** l'on choisit l'agent de séparation dans le groupe formé par l'anthracène, l'anthraquinone, l'acétamidophénol, l'acide acétylsalicylique, l'anhydride camphorique, le benzimidazole, l'acide benzène-1,2,4-tricarboxylique, l'acide-2,2-biphényldicarboxylique, la bis(4-hydroxyphényl)sulfone, la dihydroxyanthraquinone, l'hydantoïne, l'acide 3-hydroxybenzoïque ; l'acide 8-hydroxyquinoléin-5-sulfonique monohydraté, la 4-hydroxycoumarine, la 7-hydroxycoumarine, l'acide 3-hydroxynaphtalène-2-carboxylique, l'acide isophtalique, l'acide 4,4-méthylène-bis-3-hydroxynaphthalène-2-carboxylique, l'anhydride naphtalène-1,8-dicarboxylique, le phtalimide et ses sels de potassium, la phénolphtaléine, la phénothiazine, la saccharine et ses sels, le tétraphénylméthane, le triphénylène, le triphénylméthanol, ainsi que les mélanges d'au moins deux de ces substances.

2. Procédé selon la revendication 1, **caractérisé en ce que** la couche de produit comprend de l'aluminium, du fer, du cuivre, de l'argent, du zinc, de l'étain, du titane ainsi que leurs mélanges.

3. Procédé selon l'une des revendications 1 à 2, **caractérisé en ce que** la pression dans les étapes a) et b) va de $10^{-3}$ à 0,5 Pa et dans l'étape c) elle va de 10 à $2 \times 10^5$ Pa.

4. Procédé selon l'une quelconque des revendications 1 à 3, **caractérisé en ce que** le solvant comprend l'isopropanol, l'acétate d'éthyle, le butanol, l'éthanol, le benzène, la méthylisobutylcétone, la méthyléthylcétone, le perchloroéthylène ainsi que leurs mélanges.

5. Procédé selon l'une quelconque des revendications 1 à 4, **caractérisé en ce que** l'on dépose l'agent de séparation en phase vapeur à partir d'un mélange contenant une matière première céramique sous forme de granulés ou sous forme poudre, la matière première céramique formant un résidu non évaporé.

6. Procédé selon l'une quelconque des revendications 1 à 5, **caractérisé en ce que** l'agent de séparation est évaporé à partir d'un creuset possédant une surface en céramique ou de verre ou une surface en quartz.

7. Procédé selon l'une quelconque des revendications 1 à 6, **caractérisé en ce que** l'agent de séparation est introduit sous vide en continu ou à intervalles de temps dans la source d'évaporation.

8. Procédé selon l'une quelconque des revendications 1 à 7, **caractérisé en ce qu'**avant de dissoudre la couche d'agent de séparation, on dépose en phase vapeur une matière stratifiée composée de plus de deux couches, une couche d'agent de séparation se trouvant à chaque fois entre deux couches de produit.

9. Procédé selon l'une quelconque des revendications 1 à 8, **caractérisé en ce que** la couche d'agent de séparation présente une épaisseur d'environ 10 nm à environ 200 nm et la couche de produit présente une épaisseur d'environ 10 nm à environ 500 nm, en particulier d'environ 10 nm à environ 300 nm.

10. Procédé selon l'une quelconque des revendications 1 à 9, **caractérisé par** l'étape supplémentaire suivante consistant à :

    d) éliminer les résidus d'agent de séparation en les évaporant à une température pouvant atteindre 350°C et sous un vide allant de 10 à 10$^{-3}$ Pa.

11. Procédé selon la revendication 10, **caractérisé par** l'étape supplémentaire suivante consistant à :

    e) déposer des couches hydrophobes, des couches hydrophiles ou des couches de couplage contenant des d'oligomères de silane sur les surfaces purifiées des paillettes à faces planes et parallèles obtenues selon le procédé PVD, obtenues par dépôt physique en phase vapeur au cours de l'étape d).

12. Produit pouvant être obtenu selon la revendication 10, **caractérisé en ce qu'**aucune couche monomoléculaire continue d'agent de séparation n'est plus présente sur la surface.

13. Produit pouvant être obtenu selon la revendication 11, **caractérisé en ce qu'**aucune couche monomoléculaire continue d'agent de séparation n'est plus présente sur la surface.

14. Utilisation du produit selon la revendication 12 pour la production de vernis conducteurs ainsi qu'en tant que pigment métallique dans des vernis et des encres d'imprimerie.

15. Utilisation du produit selon la revendication 13 dans des vernis et des dispersions avec des solvants à base d'eau.

16. Utilisation du produit selon la revendication 12 en tant que paillette réfléchissante pour le dépôt en phase vapeur ultérieur de colorants organiques selon le procédé PVD, la matière en vrac étant mise en mouvement simultanément sous un vide allant de 10 à 10$^{-3}$ Pa.

17. Utilisation du produit selon la revendication 13 en tant que paillette réfléchissante pour le dépôt en phase vapeur ultérieur de colorants organiques selon le procédé PVD par dépôt en phase vapeur d'une matière en vrac en mouvement sous un vide allant de 10 à 10$^{-3}$ Pa.

Fig. 1